# DEMANDE DE BREVET EUROPEEN

(11) **EP 2 485 245 A2**
(43) Date de publication de la demande: **08.08.2012**
(21) Numéro de dépôt: 12153830.0
(22) Date de dépôt: 03.02.2012
(51) Int. Cl.: H01L 21/02, C23C 16/40, C23C 16/455, H01L 21/314, H01L 21/316

(54) **Procédé de fabrication d'un condensateur TiN/Ta2O5/TiN**

(30) Priorité: 04.02.2011 FR 1150922
(71) Demandeur: STMicroelectronics (Crolles 2) SAS, 38920 Crolles (FR)
(72) Inventeur: Gros-Jean, Mickaël, 38000 GRENOBLE (FR)
(74) Mandataire: de Beaumont, Michel

(57) **Abrégé**

L'invention concerne un procédé de fabrication d'un condensateur TiN/Ta₂O₅/TiN consistant à déposer sur une couche de TiN une couche de Ta₂O₅ par un procédé de dépôt de couche atomique assisté par plasma (PEALD), dans une plage de température de 200 à 250°C, en répétant les étapes successives suivantes :
dépôt d'une couche de tantale à partir d'un précurseur à une pression partielle comprise entre 0,05 et 10 Pa ; et
application d'un plasma d'oxygène à une pression d'oxygène comprise entre 1 et 2000 Pa.

## Description

### Domaine de l'invention

La présente invention concerne la fabrication de condensateurs MIM (Métal-Isolant-Métal) et plus particulièrement de condensateurs TiN/Ta₂O₅/TiN.

### Exposé de l'art antérieur

Des condensateurs de type TiN/Ta₂O₅/TiN se sont développés ces dernières années, notamment parce qu'ils sont compatibles avec la fabrication des niveaux de métallisation d'un circuit intégré et que, en raison de la constante diélectrique élevée du Ta₂O₅, ils peuvent avoir des capacités élevées pour de petites surfaces. De tels condensateurs sont par exemple utilisés pour constituer les condensateurs de points mémoire de type DRAM, de filtres radiofréquence, ou de convertisseurs analogiques-numériques.

Parmi les procédés de formation de tels condensateurs, on a proposé, pour l'élaboration de la couche de Ta₂O₅, un procédé de dépôt de couches atomiques assisté par plasma, ce procédé étant couramment désigné par l'appellation PEALD (de l'anglais Plasma-Enhanced Atomic Layer Deposition).

Ce procédé consiste à alterner des phases de dépôt de tantale à partir d'un précurseur, par exemple le produit dit TBTDET à savoir du tertiobutylimido-tris-diéthylamino tantale, et des phases d'application d'un plasma d'oxygène. Ensuite une électrode supérieure de TiN est déposée par tout procédé adapté.

Parmi les qualités que l'on attend d'un condensateur, on souhaite notamment qu'il présente un courant de fuite aussi faible que possible, de préférence inférieur à 10⁻⁷ A/cm². On cherche également à minimiser le facteur de relaxation diélectrique. Ce facteur de relaxation, FR, caractérise la variation de capacité d'un condensateur en fonction de la fréquence et est défini par la relation FR = [C(1kHz) - C(10kHz)]/C. Ainsi, ce facteur caractérise la variation de capacité C d'un condensateur entre un fonctionnement à une fréquence de 1 kilohertz et un fonctionnement à une fréquence de 10 kilohertz. Physiquement, ce facteur est lié à la présence de dipôles dans le diélectrique et au temps de relaxation de ces dipôles.

Diverses normes fixent les valeurs souhaitées du facteur de relaxation. Les normes actuelles imposent que ce facteur de relaxation soit, en pourcent, inférieur à 0,2 pour un fonctionnement d'un condensateur à 25°C et inférieur à 0,6 pour un fonctionnement d'un condensateur à 125°C.

En pratique, les condensateurs TiN/Ta₂O₅/TiN existants présentent généralement des caractéristiques insuffisantes en ce qui concerne leur courant de fuite et leur facteur de relaxation diélectrique.

Il existe donc un besoin d'amélioration de tels condensateurs.

### Résumé

Un objet de la présente invention est de prévoir un procédé de fabrication de condensateurs TiN/Ta₂O₅/TiN qui présentent des caractéristiques optimisées de courant de fuite et de facteur de relaxation diélectrique.

Un autre objet d'un mode de réalisation de la présente invention est de prévoir un condensateur présentant de telles caractéristiques optimisées.

Ainsi, un mode de réalisation de la présente invention prévoit un procédé de fabrication d'un condensateur TiN/Ta₂O₅/TiN consistant à déposer sur une couche de TiN une couche de Ta₂O₅ par un procédé de dépôt de couche atomique assisté par plasma (PEALD), dans une plage de température de 200 à 250°C, en répétant les étapes successives suivantes :
dépôt d'une couche de tantale à partir d'un précurseur à une pression partielle comprise entre 0,05 et 10 Pa ; et
application d'un plasma d'oxygène à une pression d'oxygène comprise entre 1 et 2000 Pa.

Selon un mode de réalisation de la présente invention, le précurseur de tantale est du TBTDET.

Selon un mode de réalisation de la présente invention, la pression partielle de TBTDET est comprise entre 0,5 et 2 Pa.

Selon un mode de réalisation de la présente invention, la pression partielle de TBTDET est égale à 1 Pa à 10 % près.

Selon un mode de réalisation de la présente invention, la pression partielle d'oxygène pendant les phases plasma est comprise entre 10 et 30 Pa.

Selon un mode de réalisation de la présente invention, la pression partielle d'oxygène pendant les phases plasma est égale à 25 Pa à 10 % près.

Un mode de réalisation de la présente invention prévoit un condensateur TiN/Ta₂O₅/TiN dans lequel la couche d'interface entre le TiN et le Ta₂O₅, du côté où a été amenée à croître la couche de Ta₂O₅, comprend une région d'interface entre le TiN et le Ta₂O₅ d'une épaisseur inférieure ou égale à 2 nm.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 représente l'allure de deux courbes de courant de fuite en fonction du champ électrique appliqué au diélectrique d'un condensateur TiN/Ta₂O₅/TiN ;
les figures 2A et 2B représentent l'allure de deux courbes illustrant le facteur de relaxation diélectrique d'un condensateur TiN/Ta₂O₅/TiN ;
les figures 3A et 3B représentent l'allure de la vitesse de croissance d'une couche de Ta₂O₅ déposée par PEALD ; et
la figure 4 représente un condensateur selon un mode de réalisation de la présente invention.

### Description détaillée

La présente invention se base sur une analyse du comportement de l'oxyde de tantale en tant que diélectrique. Il apparaît que, pour constituer un bon diélectrique, l'oxyde de tantale doit être déposé en couche régulière, le degré d'oxydation du tantale doit être égal à 5, et le matériau doit contenir un minimum de lacunes d'oxygène.

Jusqu'à présent, pour obtenir ce résultat, on a visé à former la couche de Ta₂O₅ dans des conditions aussi oxydantes que possible. La demanderesse a constaté que ceci présentait en fait un inconvénient et tend à oxyder la couche de TiN sous-jacente et à former une zone d'interface contenant divers composés de Ti, O, N et Ta, et que la présence de cette zone d'interface dégradait les caractéristiques du condensateur obtenu. Ainsi, la demanderesse a recherché des conditions de formation d'une couche de Ta₂O₅ par PEALD qui évitent la formation de cette zone à l'interface entre le TiN et le Ta₂O₅. Plus particulièrement, la demanderesse vise à former une couche de Ta₂O₅ sur du TiN telle que la zone d'interface ait une épaisseur inférieure à 2 nm.

Pour atteindre ce résultat, la demanderesse propose :
- pendant tout le processus de PEALD de limiter la température dans une plage de 200 à 250°C,
- pendant les étapes de dépôt de tantale à partir de TBTDET, de limiter la pression partielle de TBTDET dans une plage de 0, 05 à 10 Pa, de préférence de 0, 5 à 2 Pa, de préférence de l'ordre de 1 Pa à 10 % près, et
- pendant les phases d'application d'un plasma d'oxygène, de limiter la pression partielle d'oxygène dans une plage de 1 à 2000 Pa, de préférence de 10 à 30 Pa, de préférence à 25 Pa à 10 % près.

La demanderesse a montré qu'il résulte de ces choix des résultats optimisés en ce qui concerne le courant de fuite et le facteur de relaxation diélectrique.

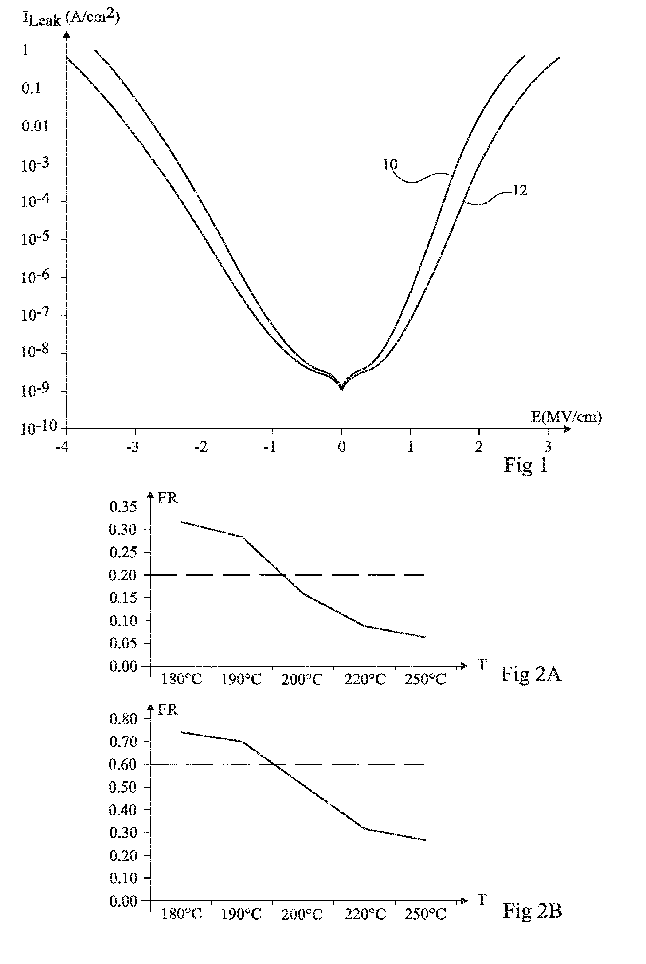

Les courbes de la figure 1 représentent l'allure de la densité de courants de fuite en ampères par cm² en fonction du champ appliqué en MV/cm, c'est-à-dire qu'une valeur 1 du champ correspond à une tension de 1 volt aux bornes d'une couche diélectrique d'une épaisseur de 10 nm (ou de 5 volts aux bornes d'une couche de 50 nm). La courbe 10 correspond à une température de dépôt de 350°C et à une pression partielle d'oxygène de l'ordre de 400 Pa pendant les phases de plasma et la courbe 12 correspond à une température de traitement de 200°C et à une pression partielle d'oxygène de l'ordre de 25 Pa pendant les phases de plasma. On constate que les courants de fuites sont beaucoup plus faibles dans le cas de la courbe 12. Ceci donne une indication générale sur le fait qu'il y a avantage à réduire la température de traitement et la pression d'oxygène pendant les phases plasma pour minimiser les courants de fuite.

Les courbes des figures 2A et 2B illustrent la valeur du facteur de relaxation FR en pourcents en fonction de la température de traitement, pour des températures de fonctionnement du condensateur respectivement de 25°C et 125°C. Ces courbes montrent que l'on a intérêt à ne pas trop réduire la température, et notamment à ne pas la réduire en dessous d'une température de 200°C si l'on veut maintenir une valeur du facteur de relaxation inférieure à la norme visée, de 0,2 % à 25°C et de 0,6 % à 125°C.

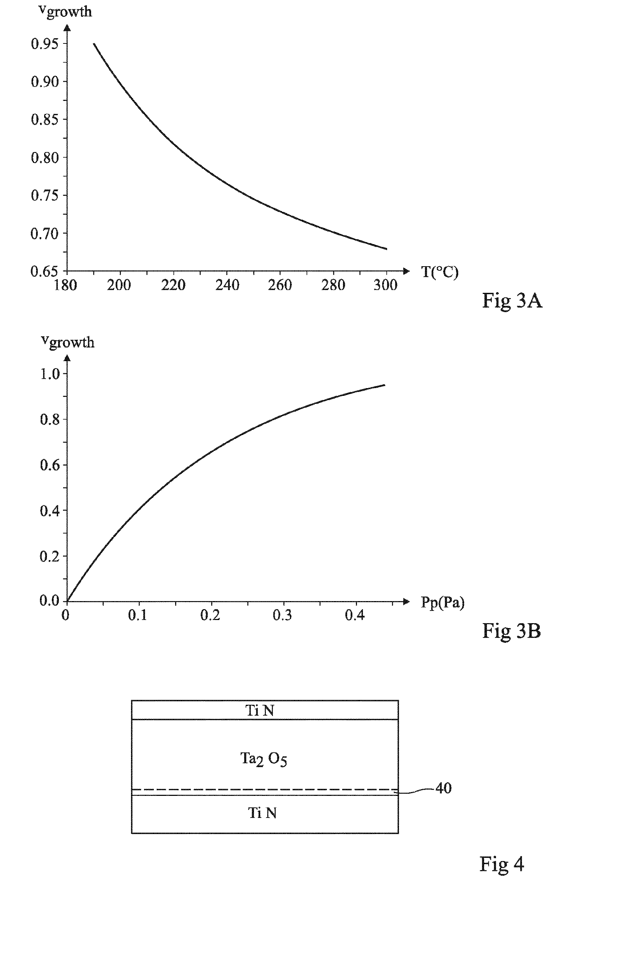

La figure 3A représente la variation de vitesse de dépôt de la couche de Ta₂O₅ en fonction de la température. On voit que pour augmenter cette vitesse, on a intérêt à décroître la température en dessous d'une valeur de 250°C. La figure 3B illustre la variation de vitesse de dépôt de la couche de Ta₂O₅ en fonction de la pression partielle de précurseur (TBTDET). On voit que si on veut maintenir une vitesse de croissance convenable, il est préférable d'avoir une pression partielle supérieure à 0,2 Pa.

C'est en fonction de toutes ces contraintes : obtention de faible courant de fuite, obtention d'un faible facteur de relaxation, obtention d'une vitesse de croissance convenable, que l'on est amené à choisir les valeurs indiquées précédemment.

De plus, la demanderesse a effectué des coupes de condensateurs obtenus dans diverses conditions de fabrication. Elle a constaté que, pour les condensateurs ayant des caractéristiques satisfaisantes, la zone à l'interface entre le TiN et le Ta₂O₅ désignée par la référence 40 en figure 4, avait une épaisseur inférieure ou égale à 2 nm. Les condensateurs de l'art antérieur présentant de moins bonnes caractéristiques se sont avérés avoir des zones d'interface (zone mixte de Ti-O-N-Ta) d'une épaisseur nettement supérieure, couramment de l'ordre de 3 nm ou plus.

Bien entendu, la présente invention est susceptible de diverses variantes et modifications qui apparaîtront à l'homme de l'art. Notamment, les diverses variantes de dépôt PEALD pourront être utilisées, dans les limites indiquées ci-dessus.

Par ailleurs, les durées des phases de dépôt de précurseur de tantale puis d'application d'un plasma oxydant pourront varier dans une plage de 50 ms à 5 s, de préférence entre 100 et 500 ms.

Par ailleurs, des traitements complémentaires connus dans la technique pourront être utilisés, notamment pour déposer la couche de TiN supérieure. De plus, on pourra aussi procéder à des recuits oxydants de la structure obtenue avant dépôt de la couche finale de TiN pour optimiser les caractéristiques du condensateur.

## Revendications

1. Procédé de fabrication d'un condensateur TiN/Ta₂O₅/TiN consistant à déposer sur une couche de TiN une couche de Ta₂O₅ par un procédé de dépôt de couche atomique assisté par plasma (PEALD), dans une plage de température de 200 à 250°C, en répétant les étapes successives suivantes :
dépôt d'une couche de tantale à partir d'un précurseur à une pression partielle comprise entre 0,05 et 10 Pa ; et
application d'un plasma d'oxygène à une pression d'oxygène comprise entre 1 et 2000 Pa.

2. Procédé selon la revendication 1, dans lequel le précurseur de tantale est du TBTDET.

3. Procédé selon la revendication 2, dans lequel la pression partielle de TBTDET est comprise entre 0,5 et 2 Pa.

4. Procédé selon la revendication 3, dans lequel la pression partielle de TBTDET est égale à 1 Pa à 10 % près.

5. Procédé selon la revendication 1, dans lequel la pression partielle d'oxygène pendant les phases plasma est comprise entre 10 et 30 Pa.

6. Procédé selon la revendication 5, dans lequel la pression partielle d'oxygène pendant les phases plasma est égale à 25 Pa à 10 % près.

7. Condensateur TiN/Ta₂O₅/TiN dans lequel la couche d'interface entre le TiN et le Ta₂O₅, du côté où a été amenée à croître la couche de Ta₂O₅, comprend une région d'interface entre le TiN et le Ta₂O₅ d'une épaisseur inférieure ou égale à 2 nm.
